(19) **Europäisches Patentamt / European Patent Office / Office européen des brevets**

(11) **EP 4 057 514 B1**

(12) **FASCICULE DE BREVET EUROPEEN**

(45) Date de publication et mention de la délivrance du brevet:
**29.04.2026 Bulletin 2026/18**

(21) Numéro de dépôt: **22161380.5**

(22) Date de dépôt: **10.03.2022**

(51) Classification Internationale des Brevets (IPC):
**H03M 1/68** *(2006.01)* **H03M 1/08** *(2006.01)*

(52) Classification Coopérative des Brevets (CPC):
**H03M 1/68**; H03M 1/0872

(54) **DISPOSITIF DE CONVERSION NUMERIQUE ANALOGIQUE A FORT RAPPORT SIGNAL/BRUIT**

DIGITAL-ANALOG-UMWANDLUNGSVORRICHTUNG MIT HOHEM SIGNAL/RAUSCH-VERHÄLTNIS

ANALOGUE-DIGITAL CONVERSION DEVICE WITH HIGH SIGNAL/NOISE RATIO

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **12.03.2021 FR 2102452**

(43) Date de publication de la demande:
**14.09.2022 Bulletin 2022/37**

(73) Titulaire: **Commissariat à l'Energie Atomique et aux Energies Alternatives**
**75015 Paris (FR)**

(72) Inventeur: **BERTRAND, François**
**38054 Grenoble Cedex 09 (FR)**

(74) Mandataire: **Santarelli**
**Tour Trinity**
**1 bis Place de la Défense**
**92400 Courbevoie (FR)**

(56) Documents cités:
**US-A- 4 410 879**

- ANALOG DEVICES: "Evaluation Board User Guide Evaluation Board for a 20-Bit, Serial Input, Voltage Output DAC", 1 August 2010 (2010-08-01), pages 1 - 16, XP055864681, Retrieved from the Internet <URL:https://www.analog.com/media/en/technical-documentation/user-guides/UG-185.pdf> [retrieved on 20211123]

- MAXIM: "Deglitching Techniques for High-Voltage R-2R DACs Deglitching Techniques for High-Voltage R-2R DACs", 1 May 2001 (2001-05-01), pages 1 - 7, XP055864683, Retrieved from the Internet <URL:https://pdfserv.maximintegrated.com/en/an/AN583.pdf> [retrieved on 20211123]

- EGAN MAURICE: "The 20-Bit DAC Is the Easiest Part of a 1-ppm-Accurate Precision Voltage Source", 1 April 2010 (2010-04-01), pages 1 - 4, XP055864279, Retrieved from the Internet <URL:https://www.analog.com/media/en/analog-dialogue/volume-44/number-2/articles/20-bit-dac-and-accurate-precision-voltage-source.pdf> [retrieved on 20211122]

- SHAH ANSHUL: "Why Does Voltage Reference Noise Matter?", vol. 54, no. 2, 1 March 2020 (2020-03-01), pages 1 - 7, XP055864672, Retrieved from the Internet <URL:https://www.analog.com/media/en/analog-dialogue/volume-54/number-1/why-does-voltage-reference-noise-matter.pdf> [retrieved on 20211122]

**Description**

**DOMAINE TECHNIQUE**

L'invention concerne le domaine des convertisseurs numérique-analogique (CNA, ou DAC pour « Digital to Analog Converter » en anglais), et avantageusement celui des CNA à haute résolution (conversion de signaux numériques dont le nombre de bits est supérieur ou égal à 16), pour lesquels un important rapport signal sur bruit (RSB, ou SNR pour « Signal to Noise Ratio » en anglais) est recherché.

**ÉTAT DE LA TECHNIQUE ANTÉRIEURE**

La conversion numérique-analogique de signaux est un vaste domaine dans lequel une multitude de types de CNA et de technologies mises en œuvre sont possibles. Pour la réalisation de CNA de haute résolution avec un fort RSB, fonctionnant de manière dynamique avec des fréquences d'échantillonnage pouvant aller jusqu'à environ 1 MHz, deux grandes technologies sont possibles : les CNA de type $\Sigma\Delta$ et ceux à réseau R-2R.

Cependant, pour ces deux technologies, les meilleurs de ces CNA peinent à dépasser un RSB supérieur à 160 dB/VHz, ce qui peut s'avérer insuffisant pour certaines applications, notamment dans le domaine de la métrologie, en particulier lorsque les CNA sont destinés à fonctionner de manière dynamique.

Dans une optique d'exploitation statique des convertisseurs, c'est-à-dire une utilisation où l'on souhaite générer une tension continue paramétrable à partir d'un mot de commande numérique, des solutions ont été proposées afin d'étendre la résolution des CNA, c'est-à-dire augmenter le nombre de bits sur lesquels la conversion est réalisée.

Par exemple, pour étendre la résolution d'un CNA, le document « Using a 16-bit DAC to generate a cost-efficient 18-DAC transfer function », 2016, Rahul Prakash, décrit la possibilité d'associer quatre CNA de 16 bits chacun pour former un CNA de 18 bits au total. Chaque CNA a pour charge de convertir un quart de la plage totale de conversion. Ainsi, pour augmenter la résolution finale de 2 bits, cette technique nécessite d'utiliser quatre CNA de même résolution. Plus généralement, pour augmenter la résolution de n bits, il convient d'associer $2^n$ CNA de même résolution. Cette technique présente toutefois plusieurs inconvénients :

- la gestion des « raccordements » entre les différents CNA est délicate et devient rédhibitoire pour des résolutions plus élevées que celles présentées dans ce document ;
- le nombre de CNA nécessaires pour élever la résolution d'un nombre important de bits est elle aussi rédhibitoire.

Une seconde technique permettant d'étendre la résolution d'un CNA, mentionnée dans le document « The 20-Bit DAC Is the Easiest Part of a 1-ppm-Accurate Precision Voltage Source» de Maurice Egan, Analog Dialogue 44-04, avril 2010, consiste à utiliser un CNA principal et un CNA secondaire associés l'un à l'autre. Le principe de cette technique est le suivant :

- chaque pas de quantification du CNA principal est subdivisé par la quantification du CNA secondaire ;
- un atténuateur est présent en sortie du CNA secondaire pour assurer que la tension pleine échelle du CNA secondaire corresponde une tension de 1 LSB (« Less Significant Bit » en anglais, ou bit de poids faible) du CNA principal, c'est-à-dire au quantum du CNA principal.

Cette technique présente l'avantage de n'utiliser que deux CNA, quel que soit le nombre de bits que l'on souhaite étendre, et permet de garder les performances de précision et de linéarité essentiellement fixées par le CNA principal.

En considérant une utilisation statique du CNA global ainsi formé, c'est-à-dire une utilisation où l'on souhaite générer une tension continue paramétrable à partir d'un mot de commande numérique, la principale limite à l'extension de résolution obtenue par cette technique est liée aux défauts de linéarité différentielle (également appelés DNL pour « Differential Non Linearity » en anglais) du CNA principal. Par exemple, si le CNA principal a un DNL de $\pm$ 0,25.LSB, subdiviser son LSB d'un facteur 4 (donc un accroissement de la résolution de 2 bits) donnera un DNL global de $\pm 1$ LSB, conduisant le CNA à la limite de monotonie.

Ce besoin d'amélioration du RSB des CNA peut se retrouver également pour des CNA de plus faible résolution (nombre de bits < 16).

La demande US 4 410 879 A, divulgue des convertisseurs numérique-analogique permettant d'augmenter la résolution de tels convertisseurs.

Document Analog Devices: "Evaluation Board User Guide Evaluation Board for a 20-Bit, Serial Input, Voltage Output DAC", concerne une carte d'évaluation pour un convertisseur numérique-analogique.

Document Maxim: "Deglitching Techniques for High-Voltage R-2R DACs Deglitching Techniques for High-Voltage R-2R DACs", concerne à techniques de réduction des glitches appliquées aux convertisseures numérique-analogique des R-2R à haute tension.

Document Egan Maurice: "The 20-Bit DAC Is the Easiest Part of a 1-ppm-Accurate Precision Voltage Source", porte sur un convertisseur numérique-analogique de haute précision, destiné aux instruments de mesure exigeants ainsi qu'aux systèmes de test et de caractérisation.

Document SHAH ANSHUL: "Why Does Voltage Reference Noise Matter?", concerne une analyse du bruit affectant les tensions de référence dans un convertisseur numérique-analogique.

## EXPOSÉ DE L'INVENTION

Un but de la présente invention est de proposer un dispositif de conversion numérique - analogique dont le RSB soit meilleur que ceux des CNA conventionnels existants, et par exemple de l'ordre de 180 dB/VHz.

Pour cela l'invention propose un dispositif de conversion numérique - analogique, comportant au moins :

- un premier convertisseur numérique-analogique, CNA, à réseau R-2R ;
- un deuxième CNA à réseau R-2R et dont une résolution $N_2$ est inférieure à une résolution $N_1$ du premier CNA ;
- un atténuateur couplé électriquement à une sortie du deuxième CNA et configuré pour délivrer en sortie une tension dont l'amplitude est égale à un quantum $q1$ du premier CNA, ou comprise entre $0,9.q1$ et $1,1.q1$ en considérant par exemple une certaine tolérance en fonction de la valeur recherchée pour le RSB et de la valeur de la résolution $N_1$, lorsqu'il reçoit en entrée une tension pleine échelle du deuxième CNA ;
- un additionneur configuré pour additionner une tension de sortie du premier CNA et la tension de sortie de l'atténuateur ;
- un circuit de pilotage numérique configuré pour délivrer sur une entrée de données du premier CNA $N_1$ bits de poids fort d'un signal numérique de $N$ bits destiné à être converti analogiquement par le dispositif, et pour délivrer sur une entrée de données du deuxième CNA ($N - N_1$) autres bits du signal numérique de $N$ bits, avec $N_2 \geq (N - N_1)$;
- un circuit de génération de référence de tension dont une sortie est couplée électriquement à une entrée d'un circuit de filtrage, une sortie du circuit de filtrage étant couplée électriquement à une entrée de référence de tension du premier CNA.

Dans ce dispositif de conversion numérique - analogique, les premier et deuxième CNA, l'atténuateur et l'additionneur forment ensemble un système de conversion dont le bruit de quantification est très inférieur au bruit de DNL du CNA principal. En outre, grâce au filtrage réalisé sur la référence de tension appliquée sur le premier CNA, dont l'impact sur le bruit global du dispositif de conversion est bien plus important que celui de la référence de tension appliquée sur le deuxième CNA, les seuls bruits limitant le RSB du dispositif correspondent au bruit de DNL, au bruit thermique du réseau R-2R du premier CNA (qui est bien plus important à celui du réseau R-2R du deuxième CNA après le dispositif d'atténuation), et au bruit des glitchs générés par le premier CNA lorsque le dispositif de conversion numérique - analogique fonctionne de manière dynamique.

En outre, ce système de conversion permet de choisir aisément le nombre de bits pouvant être convertis par le dispositif grâce au deuxième CNA qui permet d'étendre la résolution du dispositif par rapport à la résolution du premier CNA. Du fait de l'extension de la résolution du dispositif par rapport à la résolution du premier CNA obtenue grâce au fonctionnement conjoint des premier et deuxième CNA, il est possible d'obtenir des performances, en termes de RSB, qui soient inchangées tout en ayant un premier convertisseur de résolution moindre et moins couteux, dès lors que celui-ci présente un bruit thermique et des défauts de DNL rapportés à sa tension de sortie pleine échelle qui sont identiques.

Les performances obtenues en termes de précision et de linéarité du dispositif correspondent à celles du premier CNA.

Le dispositif est particulièrement bien adapté à la conversion de signaux possédant une composante statique ou quasi statique très élevée par rapport aux composantes alternatives qui le composent et au plancher de bruit recherché. Le dispositif est ainsi bien adapté pour être utilisé dans le domaine de l'instrumentation et de la métrologie, notamment celui des capteurs qui reposent sur l'utilisation d'un système bouclé et dont le traitement est effectué de manière numérique.

Le dispositif est ici utilisé de manière dynamique.

Le dispositif est avantageusement utilisé pour convertir un signal numérique d'au moins 16 bits. Le nombre de bits des signaux numériques pouvant être convertis par le dispositif est choisi via le choix des résolutions $N_1$ et $N_2$ des premier et deuxième CNA. Toutefois, ces résolutions peuvent être choisies telles que le dispositif soit configuré pour convertir des signaux numériques d'entrée de moins de 16 bits.

Le quantum $q_{total}$ du dispositif est choisi tel que la relation suivante soit vérifiée :

$$q_{total} < \frac{DNL_{crête}}{2\sqrt{3}} q_1$$

avec $q_1$ correspondant au quantum du premier CNA et $DNL_{crête}$ correspondant à la valeur crête du bruit aléatoire ajouté sur chaque échantillon généré correspondant aux défauts différentiels de linéarité du premier CNA.

Le dispositif peut comporter en outre un circuit de suppression de glitch comprenant, dans une première configuration, une entrée de données couplée électriquement à une sortie de l'additionneur, une entrée de commande couplée au circuit de pilotage numérique, et une sortie formant une sortie du dispositif de conversion numérique - analogique, ou, dans une deuxième configuration, l'entrée de données couplée électriquement à une sortie du premier CNA, l'entrée de commande couplée au circuit de pilotage numérique et la sortie couplée à une des entrées de l'additionneur. Un tel circuit permet notamment de supprimer les glitchs générés par le premier CNA (qui génèrent un bruit bien plus important que celui lié aux glitchs du deuxième CNA grâce à la forte atténuation présente en aval de ce deuxième CNA). Les glitchs sont des tensions transitoires qui apparaissent à chaque changement de valeur du signal de sortie du convertisseur et dont l'énergie est dépendante de la transition de code du signal numérique appliqué en entrée. Du fait de cette dépendance, leur impact sur le spectre de bruit de la tension de sortie du CNA dépend fortement du signal généré, ce qui se traduit par des perturbations dans la bande passante utile du signal généré. Le circuit de suppression de glitch supprime ces glitchs, et donc le bruit lié à ces glitchs. Une telle configuration peut avantageusement être mise en œuvre du fait que le dispositif de conversion est destiné à fonctionner de manière dynamique.

Le circuit de suppression de glitch peut comporter un amplificateur opérationnel monté en suiveur et un dispositif de type échantillonneur - bloqueur dont une entrée forme l'entrée de données du circuit de suppression de glitch et dont une sortie est couplée à une entrée non inverseuse de l'amplificateur opérationnel monté en suiveur, et le circuit de pilotage numérique peut être configuré pour délivrer, sur une entrée de commande d'un interrupteur commandé du dispositif de type échantillonneur - bloqueur formant l'entrée de commande du circuit de suppression de glitch, un signal de commande d'ouverture ou de fermeture de l'interrupteur commandé. La sortie de l'amplificateur opérationnel monté en suiveur peut former la sortie du circuit de suppression de glitch.

Le circuit de filtrage peut être configuré pour mettre en œuvre un filtrage passe-bas d'une référence de tension destinée à être appliquée sur son entrée.

Dans ce cas, selon une première configuration, le circuit de filtrage peut comporter au moins un circuit R-C et un amplificateur opérationnel monté en suiveur, configurés tels qu'une entrée du circuit R-C soit couplée électriquement à la sortie du circuit de génération de référence de tension, qu'une sortie du circuit R-C soit couplée à une entrée non inverseuse de l'amplificateur opérationnel et qu'une sortie de l'amplificateur opérationnel soit couplée à l'entrée de référence de tension du premier CNA.

Selon une deuxième configuration, le circuit de filtrage peut comporter au moins :

- un circuit R-C et un amplificateur opérationnel monté en suiveur, configurés tels qu'une entrée non-inverseuse de l'amplificateur opérationnel soit couplée électriquement à la sortie du circuit de génération de référence de tension, qu'une sortie de l'amplificateur opérationnel soit couplée à une entrée du circuit R-C et qu'une sortie du circuit R-C soit couplée à l'entrée de référence de tension du premier CNA ;
- un élément résistif de contre-réaction couplé entre l'entrée inverseuse de l'amplificateur opérationnel et l'entrée de référence de tension du premier CNA ;
- un élément capacitif de contre-réaction couplé entre l'entrée inverseuse de l'amplificateur opérationnel et la sortie de l'amplificateur opérationnel.

De manière avantageuse, les premier et deuxième CNA peuvent être tels que $N_1 \geq 16$ et/ou $N_2 \geq 4$.

De manière avantageuse, la résolution $N_2$ du deuxième CNA peut être telle que $N_2 > (N - N_1)$, et les $N_2 - (N - N_1)$ bits de poids fort du deuxième CNA peuvent être configurés pour être mis à 0, c'est-à-dire tels qu'un signal nul est appliqué sur les entrées du deuxième CNA correspondant aux $N_2 - (N - N_1)$ bits de poids fort du deuxième CNA.

L'invention concerne également un capteur comprenant au moins :

- un élément sensible configuré pour mesurer une grandeur physique et délivrer en sortie un signal analogique représentatif de la grandeur physique mesurée ;
- un dispositif de conversion analogique - numérique et de traitement recevant en entrée le signal analogique représentatif de la grandeur physique mesurée ;
- un correcteur dont une entrée est couplée à une sortie du dispositif de conversion analogique - numérique et de traitement et une sortie sur laquelle un signal de mesure de la grandeur physique est destiné à être délivré ;
- un dispositif de conversion numérique - analogique selon l'invention, comprenant une entrée de données à convertir couplée à la sortie du correcteur ;

- une chaîne électronique de réinjection comprenant une entrée couplée à une sortie du dispositif de conversion numérique - analogique, et une sortie couplée à une entrée de l'élément sensible qui est configuré pour soustraire un signal de sortie de la chaîne électronique de réinjection à la grandeur physique destinée à être mesurée.

De manière avantageuse, l'élément sensible peut être configuré pour mesurer un champ magnétique.

En outre, le capteur peut être configuré pour former un magnétomètre de type fluxgate ou un magnétomètre vectoriel à pompage optique.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente schématiquement un dispositif de conversion numérique - analogique, objet de la présente invention, selon un mode de réalisation particulier ;
- les figures 2 et 3 représentent schématiquement des exemples de réalisation d'un circuit de filtrage d'un dispositif de conversion numérique - analogique, objet de la présente invention ;
- la figure 4 représente schématiquement un exemple de réalisation d'un circuit de suppression de glitch d'un dispositif de conversion numérique - analogique, objet de la présente invention ;
- la figure 5 représente des exemples de signaux illustrant le principe de fonctionnement du circuit de suppression de glitch représenté sur la figure 4 ;
- la figure 6 représente un exemple de réalisation de l'atténuateur et de l'additionneur d'un dispositif de conversion numérique - analogique, objet de la présente invention ;
- les figures 7 et 8 représentent schématiquement des exemples de réalisation de capteurs comprenant chacun un dispositif de conversion numérique - analogique, objet de la présente invention ;
- la figure 9 représente schématiquement un dispositif de conversion numérique - analogique, objet de la présente invention, selon une variante de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

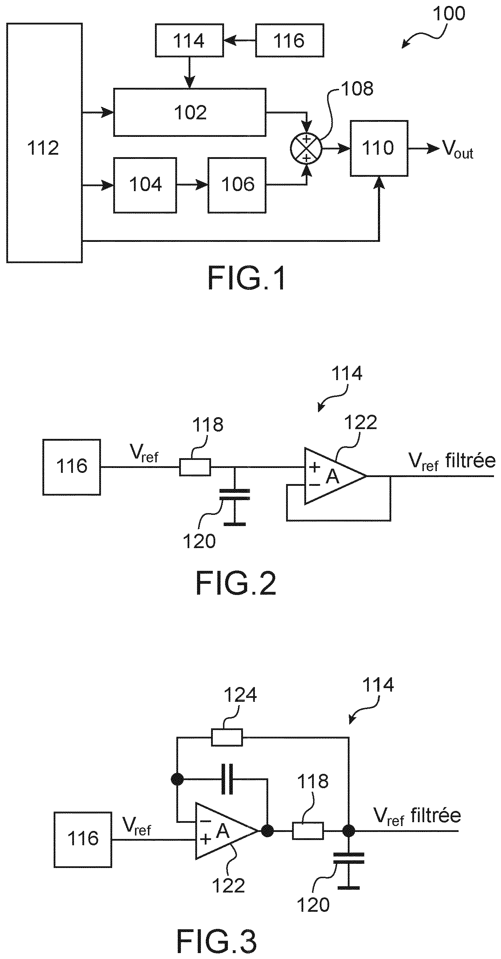

Un exemple de réalisation d'un dispositif 100 de conversion numérique - analogique selon un mode de réalisation particulier est représenté schématiquement sur la figure 1 et décrit ci-dessous.

Le dispositif 100 comporte un premier CNA 102 à réseau R-2R et un deuxième CNA 104 à réseau R-2R. Le premier CNA 102 a une résolution $N_1$ supérieure à la résolution $N_2$ du deuxième CNA 104.

Une sortie du deuxième CNA 104 est couplée électriquement à une entrée d'un atténuateur 106. L'atténuateur 106 est configuré pour délivrer en sortie une tension dont l'amplitude est égale à un quantum $q1$ du premier CNA 102, ou comprise entre 0,9.q1 et 1,1.q1 en considérant une certaine tolérance en fonction de la valeur recherchée pour le RSB et de la valeur de la résolution $N_1$, lorsqu'il reçoit en entrée l'excursion maximale du deuxième CNA 104 pouvant aller, selon l'exploitation de celui-ci de la dizaine de millivolt à quelques volts.

Les sorties de l'atténuateur 106 et du premier CNA 102 sont couplées à un additionneur 108 configuré pour additionner la tension de sortie du premier CNA 102 et la tension de sortie de l'atténuateur 106.

Une sortie de l'additionneur 108 est couplée à une entrée d'un circuit de suppression de glitch 110 qui permet de supprimer notamment les glitchs générés par le premier CNA 102. La tension de sortie du circuit de suppression de glitch 110, appelée « Vout » sur la figure 1, correspond à la tension de sortie du dispositif 100.

Le dispositif 100 comporte également un circuit de pilotage numérique 112 couplé à des entrées des premier et deuxième CNA 102, 104 et du circuit 110 de suppression de glitch, et permettant de piloter de manière coordonnée les premier et deuxième CNA 102, 104 et le circuit 110. Le circuit de pilotage numérique 112 est configuré pour délivrer sur une entrée du premier CNA 102 les $N_1$ bits de poids fort d'un signal numérique de $N$ bits destiné à être converti analogiquement par le dispositif 100, et pour délivrer sur une entrée du deuxième CNA 104 les $(N - N_1)$ autres bits du signal numérique de $N$ bits. La résolution $N_2$ du deuxième CNA 104 est telle que $N_2 \geq (N - N_1)$. A titre d'exemple, le circuit 112 peut être de type FPGA, ASIC, microcontrôleur, etc.

Le dispositif 100 comporte également un circuit de filtrage 114 interposé entre une sortie d'un circuit de génération de référence de tension 116 et une entrée de référence de tension du premier CNA 102.

Bien que non représenté sur la figure 1, le dispositif 100 comporte également un deuxième circuit de génération de référence de tension couplé à une entrée de référence de tension du deuxième CNA 104.

Dans ce dispositif 100, les premier et deuxième CNA 102, 104, l'atténuateur 106 et l'additionneur 108 forment ensemble un système de conversion numérique - analogique dont la résolution $N$ est plus grande que chacune des résolutions $N_1$ et $N_2$ des premier et deuxième CNA 102, 104. Dans ce système, le premier CNA 102 forme un CNA principal dont chaque pas de quantification est subdivisé par la quantification du deuxième CNA 104 qui forme un CNA secondaire.

En outre, dans ce système de conversion numérique - analogique, le bruit de quantification du système est abaissé bien en dessous du bruit généré par les défauts de linéarité différentielle, ou bruit de DNL, des CNA 102, 104, comme cela est expliqué ci-dessous.

D'une manière générale, le bruit de quantification $b_{quant}$ d'un CNA s'exprime par la relation :

$$b_{quant} = \frac{q}{\sqrt{12}} \tag{1}$$

avec q correspondant au quantum du CNA.

Le RSB associé à ce bruit de quantification, appelée $SNR_{quant}$, s'exprime par la relation :

$$SNR_{quant}(dB) = 6.02N_{bits} + 1.76 \tag{2}$$

avec $N_{bits}$ correspondant à la résolution du CNA.

Avec un CNA fonctionnant à une fréquence $Fe$, la puissance de bruit se trouve étalée sur toute la bande passante de Nyquist du CNA, et son SNR s'exprime en dB/VHz selon la relation suivante :

$$SNR_{quant}\left(\frac{dB}{\sqrt{Hz}}\right) = 6.02N_{bits} + 1.76 + 20\log\sqrt{\frac{F_e}{2}} \tag{3}$$

Par ailleurs, pour des petits signaux et dès lors que le CNA est activé avec des mots de commande, c'est-à-dire les signaux d'entrée numériques à convertir, non répétitifs, les défauts différentiels de linéarité du CNA peuvent s'apparenter à un rajout d'un bruit aléatoire sur chaque échantillon généré (erreur qui dépend du seul mot numérique d'entrée) de valeur crête à crête de $\pm\,DNL_{crête}$. Sa puissance de bruit peut donc être estimée à $DNL_{crête}/3$ dans l'hypothèse d'une distribution gaussienne. Le bruit des défauts de linéarité différentielle $B_{DNL}$ et son RSB associé, appelé $SNR_{DNL}$, s'expriment alors de la manière suivante :

$$b_{DNL} = \frac{DNL_{crête}}{3}q \tag{4}$$

$$SNR_{DNL}(dB) = 20\log\left(\frac{3}{DNL_{crête}}\frac{2^{Nbits-1}}{\sqrt{2}}\right) \tag{5}$$

De la même manière que le bruit de quantification, ce bruit lié aux défauts différentiels de linéarité est aussi étalé sur toute la bande passante de Nyquist du CNA, d'où son SNR exprimé en dB/VHz :

$$SNR_{DNL}\left(dB/\sqrt{Hz}\right) = 20\log\left(\frac{3}{DNL_{crête}}\frac{2^{Nbits-1}}{\sqrt{2}}\right) + 20\log\sqrt{\frac{F_e}{2}} \tag{6}$$

Ces deux sources de bruit n'étant pas corrélées, le bruit total $B_{DNL}$ en sortie d'un CNA suit alors une règle de sommation quadratique et s'exprime par la relation suivante :

$$b_{out} = \sqrt{b_{quant}^2 + b_{DNL}^2} \tag{7}$$

Le RSB correspondant s'exprime alors par la relation :

$$SNR_{OUT} = 20 \log\left(\frac{2^{Nbits-1}}{\sqrt{2}\, b_{out}}\right) \tag{8}$$

Pour rendre le bruit de quantification $b_{quant}$ négligeable par rapport au bruit total de sortie $b_{out}$, le bruit de quantification $b_{quant}$ doit être maintenu très inférieur au bruit de DNL $b_{DNL}$. Par exemple, et pour la suite de l'exposé, il peut être choisi un bruit $b_{quant}$ selon la relation (9) qui permet de limiter à +0,26 dB l'augmentation du bruit total de sortie $b_{out}$ liée au bruit de quantification $b_{quant}$ :

$$b_{quant} < b_{DNL}/4 \tag{9}$$

En combinant les relations (1), (4) et (9) ci-dessus, et en considérant $q_{total}$ comme étant le quantum du dispositif 100 et $q_1$ comme étant le quantum du premier CNA 102, les CNA 102, 104 peuvent être choisis ou conçus tels que la relation suivante soit vérifiée :

$$q_{total} < \frac{DNL_{crête}}{2\sqrt{3}} q_1 \tag{10}$$

Il convient de noter que le bruit de quantification et le bruit de DNL du deuxième CNA 104 sont, au sein du dispositif 100, bien inférieurs à ceux du premier CNA 102. Ainsi, la valeur du quantum du quantum du deuxième CNA 104 n'intervient pas dans l'équation (10) ci-dessus.

Autrement dit, le quantum $q_{total}$ du dispositif 100 est choisi tel que la relation (10) ci-dessus soit vérifiée, avec $q_1$ correspondant au quantum du premier CNA 102 et $DNL_{crête}$ correspondant à la valeur crête du bruit aléatoire ajouté sur chaque échantillon généré correspondant aux défauts différentiels de linéarité du premier CNA 102.

Les valeurs de $DNL_{crête}$ des CNA 102, 104, exprimées en fraction du quantum de ces CNA 102, 104, et fournies par le fabriquant des CNA 102, 104 dans les datasheets correspondantes, dépendent de la qualité de fabrication des CNA 102, 104 et aussi de la résolution des CNA 102, 104 : plus ces résolutions seront élevées, plus il est difficile d'obtenir des valeurs de $DNL_{crête}$ faibles, et inversement. Par exemple, pour un premier CNA 102 de résolution $N_1$ égale à 20 bits, le $DNL_{crête}$ de ce CNA peut être de l'ordre $0,3.q_1$. Le quantum $q_{total}$ du dispositif 100 respectant la relation (10) ci-dessus est alors inférieur à environ $q_1/12$, ce qui est obtenu en choisissant un deuxième CNA 104 de résolution $N_2$ d'au moins 4 bits. La valeur de la résolution $N_2$ est choisie pour atteindre le facteur d'atténuation entre les quantums $q_1$ et $q_{total}$, ici égal à 12, avec $N_2 = \ln 12/\ln 2 = 3,5$, ce qui donne 4 bits lorsque le résultat obtenu est arrondi au nombre entier supérieur. Selon un autre exemple, pour un premier CNA 104 de résolution moindre, par exemple $N_1 = 16$ bits, le $DNL_{crête}$ de ce premier CNA peut être plus faible et par exemple égal à environ $0,1.q_1$. Le quantum $q_{total}$ du dispositif 100 respectant la relation (10) ci-dessus est alors inférieur à environ $q_1/35$, ce qui est obtenu en choisissant un deuxième CNA 104 de résolution $N_2$ d'au moins 6 bits.

La démonstration ci-dessus décrit comment est choisie la valeur minimale de la résolution $N_2$ du deuxième CNA 104 pour minimiser le bruit de quantification dans le dispositif 100. De manière avantageuse, la valeur de la résolution $N_2$ du deuxième CNA 104 est choisie comme étant supérieure à cette valeur minimale, par exemple de 4 bits supplémentaire par rapport à cette valeur minimale, ce qui permet de conférer les propriétés d'un bruit blanc lié au seul bruit de DNL. En effet, un bruit de quantification « pur » peut générer un spectre de raies et non un bruit blanc. Choisir une valeur de résolution $N_2$ du deuxième CNA 104 supérieure à la valeur minimale indiquée ci-dessus permet d'éviter que ces raies où se concentre la puissance de bruit dépassent le bruit de DNL. Par exemple, si la valeur minimale de la résolution $N_2$ est de 4 bits, le deuxième CNA 104 peut être choisi tel que la valeur de sa résolution $N_2$ soit de 8 bits.

Dans le dispositif 100 décrit ici, outre la minimisation du bruit de quantification apportée par le système formé par les premier et deuxième CNA 102, 104, l'atténuateur 106 et l'additionneur 108, l'augmentation de la valeur du RSB du dispositif 100 est obtenue également grâce au filtrage de la référence de tension délivrée par le circuit 116 et destinée à être appliquée en entrée du premier CNA 102, ce filtrage étant réalisé par le circuit de filtrage 114.

En effet, deux principales sources de bruit analogiques sont présentes dans un CNA à réseau R-2R :

- le bruit interne du réseau R-2R ;
- le bruit apporté par la référence de tension appliquée en entrée du CNA, qui est généralement au moins 10 fois supérieur au bruit interne du réseau R-2R.

Dans le dispositif 100, le circuit de filtrage 114 permet de minimiser et rendre négligeable le bruit apporté par la référence de tension par rapport au bruit interne des réseaux R-2R des CNA 102, 104, et donc que le bruit analogique du dispositif 100 corresponde sensiblement à ce bruit interne des réseaux R-2R des CNA 102, 104.

En effet, le bruit du réseau R-2R, appelé $b_{R\text{-}2R}$, d'un CNA correspond essentiellement au bruit thermique du réseau R-2R du CNA, et dépend donc de l'impédance équivalente du réseau. Ce bruit du réseau R-2R est propre à la constitution du CNA et sa valeur $b_{R-2R}$ ne peut être réduite. Par contre, son RSB associé est, dans une certaine mesure, ajustable car directement lié à l'excursion de la tension de sortie du CNA, appelée $\Delta V_{out\,max\,c-c}$. Ce RSB, appelée $SNR_{R-2R}$, s'exprime par la relation suivante :

$$SNR_{R-2R}\left(dB/\sqrt{Hz}\right) = 20\log\left(\frac{\Delta V_{out\,\max\,c-c}}{2\sqrt{2}\,b_{R-2R}}\right) \qquad (11)$$

La valeur de la tension de sortie d'un CNA est directement proportionnelle à celle de la tension de référence appliquée sur l'entrée de référence de tension de ce CNA. Ainsi, la contribution du bruit de la référence de tension $b_{Ref}$ au bruit total $b_{out}$ en sortie du CNA est d'autant plus importante que la valeur de la tension de sortie du CNA approche de la valeur de la tension pleine échelle du CNA. Il est ainsi possible d'écrire la relation suivante :

$$b_{out} \equiv b_{Ref}\,\frac{Code}{2^{Nbits}} \qquad (12)$$

avec la variable « Code », également appelée « Data DAC », correspondant à la consigne numérique d'entrée à convertir par le dispositif 100.

De manière avantageuse, le circuit de filtrage 114 est configuré pour mettre en œuvre un filtrage passe bas. La sévérité du filtrage (ordre, fréquence de coupure) à mettre en œuvre dépend du bruit de la référence de tension choisie et de la fréquence à partir de laquelle l'obtention du RSB optimisé est souhaitée (donnée propre à chaque application).

Un premier exemple de réalisation du circuit de filtrage 114 est représenté schématiquement sur la figure 2.

Dans ce premier exemple de réalisation, le circuit de filtrage 114 comporte un élément résistif 118 et un élément capacitif 120 couplés électriquement en série et formant un circuit R-C. Une entrée du circuit R-C, formée par une première électrode de l'élément résistif 118, est couplée à la sortie du circuit de génération de référence de tension 116 sur laquelle est délivrée une référence de tension $V_{ref}$. Le circuit de filtrage 114 comporte également un amplificateur opérationnel 122 monté en suiveur. L'amplificateur opérationnel 122 est avantageusement choisi tel qu'il apporte le moins de bruit possible. L'entrée non inverseuse de l'amplificateur opérationnel 122 est couplée à une sortie du circuit R-C formée par une deuxième électrode de l'élément résistif 118 à laquelle l'une des électrodes de l'élément capacitif 120 est couplée électriquement. La sortie de l'amplificateur opérationnel 122, sur laquelle est délivrée la référence de tension filtrée « $V_{ref}$ filtrée », est couplée à l'entrée de référence de tension du premier CNA 102.

Le bruit des références de tension, même choisies parmi les moins bruyantes du marché, plafonne autour de 180nV/√Hz pour une tension de 10V. Ce bruit est bien plus important que celui d'un réseau R-2R d'un CNA, par exemple de l'ordre de 7,5nV/√Hz. En considérant une référence de tension générant un bruit de 180nV/√Hz, avec un objectif de 7,5nV/√Hz dès 1Hz, l'atténuation réalisée devra être de 24 (27,6 dB), et la fréquence de coupure pour un ordre 1 de 0,04 Hz (constante de temps de 4 secondes), ce qui est atteignable avec un élément résistif 118 de valeur R = 10 kΩ et un élément capacitif de valeur C = 400 μF.

Des circuits de filtrage 114 différents de celui décrit ci-dessus sont possibles selon les applications du dispositif 100, notamment si celles-ci requièrent des spécifications élevées sur la précision de conversion de la composante continue, en plus du haut niveau de RSB recherché. Par exemple, un filtrage à fréquence de coupure basse pour respecter l'atténuation du bruit à la fréquence désirée peut imposer un couple de valeurs R-C importantes. Le courant de fuite inhérent à l'élément capacitif 120 peut provoquer une légère chute de tension aux bornes de l'élément résistif 118 et modifier la composante continue du signal de sortie du dispositif 100. Dans ce cas, il peut être envisagé un montage avec une contre réaction en charge de maintenir la précision de la composante continue de la référence de tension, comme par exemple représenté sur la figure 3.

Dans le deuxième exemple de réalisation du circuit de filtrage 114 représenté sur la figure 3, l'entrée non-inverseuse de l'amplificateur opérationnel 122 est couplée à la sortie du circuit de génération de référence de tension 116. La sortie de l'amplificateur opérationnel 122 est couplée à l'entrée du circuit R-C formé par l'élément résistif 118 et l'élément capacitif 120. La sortie du circuit R-C est couplée à l'entrée de référence de tension du premier CNA 102. Le circuit de filtrage 114 comporte également un élément résistif de contre-réaction 124 couplé entre l'entrée inverseuse de l'amplificateur opérationnel 122 et l'entrée de référence de tension du premier CNA 102, et un élément capacitif de contre-réaction 126 couplé entre l'entrée inverseuse de l'amplificateur opérationnel 122 et la sortie de l'amplificateur opérationnel 122.

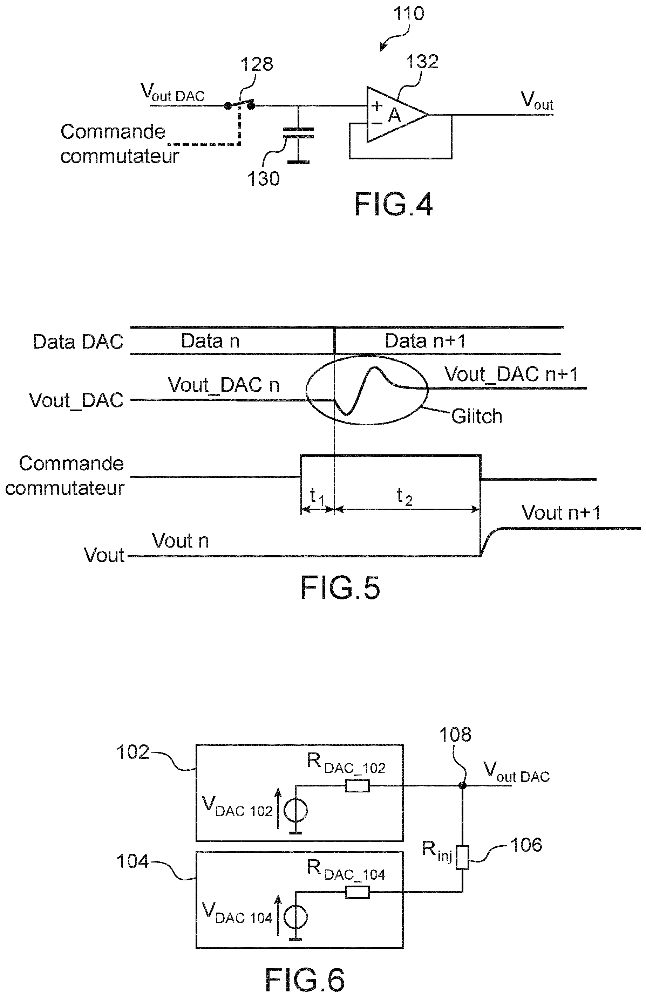

La minimisation du bruit du dispositif 100 passe également avantageusement par l'utilisation du circuit de suppression de glitch 110. De manière avantageuse, le circuit de suppression de glitch 110 peut comporter un dispositif de type échantillonneur - bloqueur (« sample and hold » en anglais). Un exemple de réalisation d'un tel circuit de suppression de glitch 110 est représenté schématiquement sur la figure 4. Dans cet exemple de réalisation, le dispositif de type échantillonneur - bloqueur du circuit 110 comporte un interrupteur commandé 128 dont une première borne forme une entrée de données du circuit 110 couplée à la sortie de l'additionneur 108. Sur la figure 4, le signal délivré en sortie de l'additionneur 108 est appelé $V_{out\,DAC}$. Une entrée de commande de cet interrupteur 128 est couplée au circuit de pilotage numérique 112 qui commande le circuit 110 via l'envoi d'un signal de commande d'ouverture ou de fermeture de l'interrupteur 128, appelé « Commande commutateur » sur la figure 4. Une deuxième borne de l'interrupteur commandé 128 est couplée à une électrode d'un élément capacitif 130 du dispositif de type échantillonneur - bloqueur. La sortie du dispositif de type échantillonneur - bloqueur, formée par le nœud de connexion entre l'élément capacitif 130 et l'interrupteur commandé 128, est couplée à l'entrée non inverseuse d'un amplificateur opérationnel 132 monté en suiveur (entrée inverseuse couplée à sa sortie). La tension délivrée en sortie de l'amplificateur opérationnel 132 correspond au signal de sortie du circuit 110, c'est-à-dire le signal de sortie $V_{out}$ du dispositif 100.

Grâce au circuit de suppression de glitch 110, toutes les composantes du spectre généré par les glitchs du premier CNA 102, y compris celles dites « basses fréquences » (et, dans une moindre mesure, du deuxième CNA 104) sont éliminées.

Le principe de fonctionnement du circuit de suppression de glitch 110 précédemment décrit est expliqué ci-dessous, en lien avec la figure 5. Sur cette figure, un glitch apparait sur la tension $V_{out\_DAC}$ délivrée en sortie de l'additionneur 108 en raison d'un changement de valeur de la donnée numérique d'entrée « Data DAC » à convertir par le dispositif 100 (passage de la donnée « Data n » à la donnée « Data n+1 »). Une durée t1 avant ce changement de valeur de « Data DAC », un ordre d'ouverture de l'interrupteur commandé 128 est envoyé par le circuit 112 et la valeur de $V_{out\_DAC}$ reste mémorisée dans l'élément capacitif 130. A l'instant du changement de consigne et pendant toute une durée t2, la valeur de la tension $V_{out}$ délivrée en sortie du circuit 110 ne change pas et reste égale à la valeur mémorisée dans l'élément capacitif 130, indépendamment de la présence du glitch généré suite au changement de consigne, du fait que l'interrupteur commandé 128 soit toujours en position ouverte. Après la durée t2, le glitch ayant disparu, l'interrupteur commandé 128 est refermé et $V_{out}$ prend la nouvelle valeur $V_{out}$ n+1 de manière maitrisée.

Pour avoir un fonctionnement optimal du circuit de suppression de glitch 110, les durées t1 et t2 peuvent être choisies telles que lors de la durée $t_1$ soit légèrement supérieure au délai d'ouverture de l'interrupteur commandé 128, et que la durée t2 soit légèrement supérieure à la durée maximale des glitchs générés au sein du dispositif 100. Par exemple, les délais de commutation des interrupteurs analogiques étant de l'ordre de 100 ns, la durée t1 peut être choisie égale à environ 200 ns et la durée t2 peut être choisie égale à environ 1 µs (la valeur de cette durée étant toutefois dépendante de la durée des glitchs générés par les CNA utilisés dans le dispositif 100, et notamment le premier CNA 102).

En outre, l'amplificateur opérationnel 132 est choisi tel qu'il présente avantageusement un bruit d'entrée inférieur au bruit du réseau R-2R du premier CNA 102 pour contribuer le moins possible au bruit final de sortie du dispositif 100. Par exemple, il est possible de choisir un amplificateur opérationnel 132 dont le bruit d'entrée est de 2,8 nV/√Hz pour une fréquence supérieure à 50 Hz, avec un courant de polarisation maximal de 2 nA (dont l'effet maximal sur la tension aux bornes de l'élément capacité 130 pendant l'ouverture de l'interrupteur commandé 128 est équivalent à $0,02.q_1$, c'est-à-dire est négligeable).

Dans le dispositif de type échantillonneur - bloqueur du circuit 110, la valeur C de l'élément capacitif 130 est de préférence maximisée dans la limite de la bande passante souhaitée par le système de conversion numérique-analogique car :

- l'absorption par l'élément capacitif 130 de la charge d'injection Q nécessaire pour ouvrir et fermer l'interrupteur commandé 128, exprimée en pC, a pour effet de modifier la tension aux bornes de l'élément capacitif 130 de la valeur $\Delta U = Q/C$. Ainsi plus C est grand, moins la tension à ses bornes est perturbée ;
- cela permet à l'élément capacitif 130 de mieux garder en mémoire la valeur de la tension « mémorisée », la tension du condensateur se chargeant ou se déchargeant en fonction du courant de polarisation de l'amplificateur opérationnel 132.

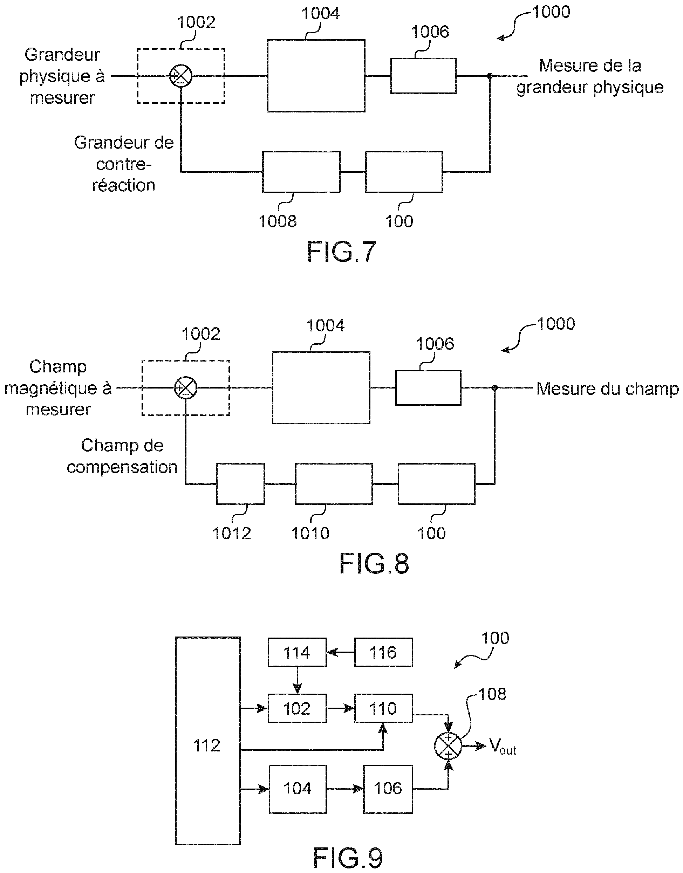

Dans l'exemple de réalisation précédemment décrit, le circuit de suppression de glitch 110 comporte son entrée de données couplée à la sortie de l'additionneur 108, et la sortie du circuit 110 forme la sortie du dispositif 100. En variante, il est possible que l'entrée de données du circuit de suppression de glitch 110 soit couplée à la sortie du premier CNA 102 et que la sortie du circuit 110 soit couplée à l'une des entrées de l'additionneur 108. Dans ce cas, la sortie de l'additionneur 108 forme la sortie du dispositif 100. Une telle variante est représentée schématiquement sur la figure 9.

La figure 6 décrite ci-dessous représente un exemple de réalisation de l'atténuateur 106 et de l'additionneur 108.

Dans cet exemple de réalisation, afin de limiter au maximum l'utilisation d'éléments actifs pouvant être des sources potentielles de détérioration du bruit, l'atténuation analogique, appelée « Att », réalisée sur la tension de sortie du deuxième CNA 104 est obtenue en utilisant une résistance d'injection, de valeur $R_{inj}$ et formant l'atténuateur 106. Une première borne de la résistance d'injection 106 est couplée à la sortie du deuxième CNA 104. En outre, dans cet exemple de réalisation, l'additionneur 108 correspond à un couplage réalisé entre la sortie du premier CNA 102 et une deuxième borne de la résistance d'injection 106.

En considérant les résistances internes de sortie des CNA 102, 104, appelées respectivement $R_{DAC\_102}$ et

$R_{DAC\_104}$, la tension $V_{out\_DAC}$ obtenue en sortie de l'additionneur 108 s'exprime par la relation :

$$V_{out\_DAC} = \frac{1}{R_{DAC\_102}+R_{DAC\_104}+R_{inj}}[V_{DAC\_104}(R_{DAC\_104} + R_{Inj}) + V_{DAC\_102}(R_{DAC\_102})] \qquad (13)$$

En considérant $R_{inj} \gg R_{DAC\_102}$ et $R_{DAC-104}$, l'équation (13) peut se simplifier de la manière suivante :

$$Vout \approx V_{DAC_{102}} + Att \cdot V_{DAC\_104} \qquad (14)$$

Avec « Att » correspondant au coefficient d'atténuation appliqué par l'atténuateur 106 sur la tension de sortie du deuxième CNA 104 et s'exprimant par la relation suivante :

$$Att \approx \frac{R_{DAC\_102}}{R_{Inj}} \qquad (15)$$

Dans le dispositif 100 précédemment décrit, grâce à l'abaissement du bruit de quantification devant celui généré par les défauts de linéarité différentiels obtenu par le système de conversion numérique - analogique formé par les premier et deuxième CNA 102, 104, l'atténuateur 106 et l'additionneur 108, au filtrage de la référence de tension par le circuit de filtrage 114 et à l'élimination des glitchs par le circuit de suppression de glitchs 110, le RSB total, appelé $SNR_{total}$, atteignable par le dispositif 100 n'est limité que par les deux RSB associés aux deux sources de bruit irréductibles que sont le réseau R-2R et les défauts de linéarité différentiels, et s'exprime par la relation suivante :

$$SNR_{Total} = 10log\left(\frac{1}{10^{-SNR_{DNL}/10}+10^{-SNR_{R-2R}/10}}\right) \qquad (16)$$

A titre d'exemple, en choisissant un premier CNA 102 de résolution égale à 20 bits, exploité avec une excursion de sa tension de sortie maximale à $\pm 10V$ (qui correspond à l'application d'une référence de tension de 10 V sur le premier CNA 102) et avec une fréquence d'échantillonnage Fe égale à 100 kHz (fréquence permettant un fonctionnement correct du circuit de suppression de glitchs 110), un $DNL_{crête}$ de l'ordre $0,3.q_1$, un réseau R-2R d'impédance égale à 3,4 kΩ dont le bruit est de 7,5 nV/√Hz, les valeurs des différents RSB obtenus sont : $SNR_{R-2R}$ = 182,5 dB/√Hz et $SNR_{DNL}$ = 178,4 dB/√Hz. Le RSB total atteignable se situe alors à 177dB/√Hz, soit un gain d'environ 15dB par rapport à l'état de l'art atteignable par une mise en œuvre conventionnelle des meilleurs convertisseurs numérique - analogique du marché.

Dans l'exemple de réalisation précédemment, la résolution $N_2$ du deuxième CNA 104 est d'au moins 4 bits pour rendre négligeable le bruit de quantification devant celui des défauts de linéarité différentiels. De manière avantageuse, il est possible de choisir une valeur de la résolution $N_2$ plus importante, par exemple égale à 8 bits dans l'exemple précédemment décrit, le dispositif 100 réalisant dans ce cas une conversion numérique - analogique de 28 bits au total.

Il est également possible de choisir les premier et deuxième CNA 102, 104 tels que la somme des résolutions $N_1$ et $N_2$ soit supérieure au nombre de bits du signal numérique à convertir par le dispositif 100. Plus particulièrement, la résolution $N_2$ du deuxième CNA 104 peut être telle que $N_2 > (N - N_1)$, et les $N_2 - (N - N_1)$ bits de poids fort du deuxième CNA 104 peuvent être configurés pour être mis à 0, c'est-à-dire tels qu'un signal nul est appliqué sur les entrées du deuxième CNA 104 correspondant *aux* $N_2 - (N - N_1)$ bits de poids fort du deuxième CNA 104.

Dans l'exemple de réalisation précédemment décrit, il est possible d'avoir $N_1$ = 20 bits et $N_2$ = 16 bits, avec toutefois le dispositif 100 réalisant une conversion d'un signal de 28 bits seulement. Dans ce cas, une partie des bits de poids fort (les 8 bits de poids fort dans l'exemple décrit ici) du deuxième CNA 104 sont laissés à 0. Cela permet au deuxième CNA 104 de contribuer à la fonction d'atténuation remplie par l'atténuateur 106, comme cela est expliqué ci-dessous.

En effet, la tension de sortie $V_{out\_DAC}$ obtenue par la somme du signal délivré par les premier et deuxième CNA 102, 104 s'exprime de la manière suivante :

$$V_{OUT\_DAC} = \frac{2V_{REF\_102}}{2^{N_1}-1}N_H - V_{REF\_102} + \frac{V_{REF\_104}}{2^{N_2}}N_L\,2^{N_2-L-p}Att \qquad (17)$$

Avec :

$V_{REF\_102}$ correspondant à la valeur de la référence de tension appliquée en entrée du premier CNA 102 ;

$V_{REF\_104}$ correspondant à la valeur de la référence de tension appliquée en entrée du deuxième CNA 104, et qui est par exemple égale à 5 V dans l'exemple précédemment décrit ;

$N_H$ correspondant à un nombre binaire positif compris entre 0 et $2^{N1}$ - 1 et appliqué en entrée du premier CNA 102 ;

$N_L$ correspondant à un nombre binaire positif compris entre 0 et $2^{NL}$ - 1 et appliqué en entrée du deuxième CNA 104 ;

$L$ correspondant au nombre de bits du deuxième CNA 104 utilisés pour la conversion, c'est-à-dire $N - N_1$ qui correspond au nombre de bits « utiles » de l'extension de bits);

p correspondant au nombre de bits mis à 0 sur les poids forts du mot du deuxième CNA 104, c'est-à-dire $N_2 - (N - N_1)$;

En considérant que $2^{N1}$ - 1 $\approx 2^{N1}$ compte tenu de la forte valeur de $N_1$, l'équation (17) peut s'écrire telle que :

$$V_{OUT\_DAC} \approx \frac{2V_{REF\_102}2^L}{2^{N1+L}} N_H - V_{REF\_102} + \frac{V_{REF\_104}}{2^{L+p}} N_L \, Att \qquad (18)$$

En considérant que les premier et deuxième CNA 102, 104, l'atténuateur 106 et l'additionneur 108 forment un seul CNA de résolution $(N_1+L)$ bits, la tension de sortie $V_{OUT\_DAC}$ s'exprime également par l'équation suivante :

$$V_{OUT\_DAC} = \frac{2V_{REF\_102}}{2^{N1+L}} (2^L N_H + N_L) - V_{REF\_102} \qquad (19)$$

La combinaison des équations (18) et (19) aboutit à la condition suivante :

$$\frac{V_{REF\_104}}{2^{L+p}} \, Att = \frac{2V_{REF\_102}}{2^{N1+L}} \qquad (20)$$

La valeur de l'atténuation « Att » à mettre en œuvre est alors :

$$Att \, = 2^p \, \frac{2V_{REF\_102}}{V_{REF\_104} \, 2^{N1}} \qquad (21)$$

Ainsi, avec les valeurs de $V_{REF\text{-}102}$ = 10V, $V_{REF\_104}$ = 5V, $N_1$ = 20bits, si p est choisi égal à 0 (tension pleine échelle du deuxième CNA 104 égale à la référence de tension injectée dans celui-ci), il faudrait mettre en œuvre une atténuation analogique (correspondant au coefficient d'atténuation appliqué par l'atténuateur 106) extrêmement sévère d'une valeur de 262144, qui pourrait s'avérer difficile à mettre en œuvre avec l'architecture de sommation mise en œuvre dans le dispositif 100. Par contre, en choisissant par exemple un deuxième CNA 104 de résolution $N_2$ = 16 bits, dont seuls les 8 bits de poids faible viendront se sommer aux 20 bits du premier CNA 104 et en fixant à 0 les 8 bits de poids fort (p=8), le deuxième CNA 104 participe à la prise en charge de l'atténuation d'un facteur 256, et l'atténuation analogique qui reste à appliquer n'est alors plus que de 1024, valeur qui devient plus facile à mettre en œuvre. En considérant l'équation (15) précédemment décrite, avec un premier CNA 102 présentant une résistance de sortie $R_{DAC\_102}$ égale à 3,4 kΩ et un deuxième CNA 104 présentant une résistance de sortie $R_{DAC\text{-}104}$ égale à 6,2 kΩ, un facteur d'atténuation Att égal à 1024 est obtenu en choisissant une résistance d'injection 106 telle que $R_{inj}$ = 3,482 MΩ.

Dans l'exemple précédemment décrit, la valeur $R_{inj}$ étant très supérieure à $R_{DAC\_102}$, la bande passante du dispositif 100 est fixée par le produit $R_{DAC\_102}$ x C, avec C correspondant à la valeur du condensateur 130 du circuit de suppression de glitchs 110. Par exemple, avec $R_{DAC\_102}$ = 3,4 kΩ et pour une bande passante souhaitée de 10 kHz, la valeur C du condensateur 103 peut être choisie égale à 4,7 nF. En choisissant un interrupteur commandé 128 à faible charge d'injection, par exemple égale à 0,19 pC, la modification de la tension aux bornes du condensateur 130 peut être estimée à 40 μV, soit l'équivalent de deux fois la valeur de $q_1$, soit une perturbation non négligeable en soi Toutefois, cette perturbation est indépendante du mot numérique appliqué en entrée du dispositif 100 et est constante quelle que soit la tension de sortie, contrairement aux glitchs générés par le premier CNA 102. Le spectre de perturbation généré est alors porté à la fréquence d'échantillonnage et à ses multiples harmoniques, c'est-à-dire hors de la bande passante du signal utile. Un filtrage passe bas situé en aval pourra, le cas échéant, les éliminer si celles-ci se s'avéraient gênantes pour l'application.

Le dispositif 100 précédemment décrit est utilisé de manière dynamique. Lorsque le dispositif 100 est destiné à être utilisé à une faible fréquence de fonctionnement, le dispositif 100 peut ne pas comporter le circuit de suppression de glitchs 110.

Le dispositif 100 est avantageusement utilisé au sein d'un capteur reposant sur l'utilisation d'un système bouclé et dont le traitement est effectué de manière numérique. Exemple de réalisation d'un tel capteur 1000 est représenté schématiquement sur la figure 7.

Le capteur 1000 comporte un élément sensible 1002 recevant en entrée une grandeur physique à mesurer et une grandeur de contre réaction délivrée par le capteur 1000. Le signal d'erreur résultant délivré en sortie de l'élément sensible 1002 est appliqué en entrée d'un circuit 1004 de conversion analogique - numérique et de traitement. Celui-ci a en charge de conditionner le signal d'erreur pour le présenter en entrée du correcteur 1006. Le contenu de ce traitement est d'une complexité très variable car propre à la nature du signal d'erreur délivré par l'élément sensible (application de gains, de filtrages, opérations de démodulation, etc.). Le correcteur 1006, comprenant typiquement d'un intégrateur, délivre un signal de sortie du capteur 1000 qui correspond à une mesure numérique de la grandeur physique à mesurer. Ce signal est également utilisé pour générer la grandeur de contre réaction via le dispositif de conversion numérique - analogique 100 suivi de la chaine de réinjection 1008 en charge de convertir la tension de sortie du dispositif 100 en une grandeur homogène à la grandeur physique à mesurer. Le signal de sortie de la chaîne de réaction 1008 est appliqué en entrée de l'élément sensible 1002.

Dans un tel capteur 1000 où la mesure de la grandeur physique est prélevée sur la consigne du signal de contre réaction, la qualité de la mesure dépend directement de la qualité de cette chaine de contre réaction. Le dispositif numérique - analogique 100 est alors un élément critique de ce type d'architecture puisque tout défaut ou bruit du dispositif 100 se retrouve sur la grandeur mesurée.

Le capteur 1000 correspond par exemple à un capteur de mesure magnétique, tel qu'un magnétomètre vectoriel à pompage optique à hélium 4 dit « champ nul » ou encore un magnétomètre de type fluxgate. La figure 8 représente schématiquement le capteur 1000 dans une telle configuration.

Comme sur le schéma de la figure 7, le capteur 1000 représenté sur la figure 8 comporte l'élément sensible 1002 qui est ici configuré pour mesurer un champ magnétique. Le signal de mesure délivré en sortie de l'élément sensible 1002 est appliqué en entrée du circuit 1004 qui, dans la configuration de la figure 8, met en œuvre des fonctions de sonde, d'amplification de signal, de conversion analogique - numérique et de traitement. Un signal de sortie numérique délivré par le circuit 1004 est appliqué en entrée du correcteur 1006 qui correspond ici à un correcteur intégral pur (correcteur I) ou à effet proportionnel/intégral (correcteur PI). Ce correcteur 1006 délivre en sortie un signal de sortie du capteur 1000 qui correspond à une mesure numérique du champ magnétique à mesurer. Le capteur 1000 comporte également une boucle de rétroaction comprenant le dispositif 100 recevant en entrée le signal de sortie du capteur 1000. Le signal de sortie analogique du dispositif 100 est appliqué en entrée du dispositif 1010 en charge de convertir la consigne de tension en un courant. Ce courant est ensuite appliqué en entrée d'une bobine 1012 en charge de générer le champ magnétique de compensation appliqué en entrée de l'élément sensible 1002.

Pour le capteur 1000 représenté sur la figure 7, le champ magnétique DC à mesurer s'étend typiquement sur une plage de $\pm 70\mu T$ pour la mesure du champ terrestre, tout en ayant un niveau de bruit capteur extrêmement faible qui peut atteindre $50fT/\sqrt{Hz}$, le tout avec une bande de mesure de quelques kilohertz. Dans ce cas, le besoin en terme de RSB imposé au signal de contre réaction (ici les champs magnétiques de compensation qui imposeront un champ nul au sein de l'élément sensible 1002 du capteur 1000) s'établit alors à $180dB/\sqrt{Hz}$. Le dispositif de conversion numérique - analogique 100 tel que décrit précédemment y trouve alors pleinement son intérêt et permet de répondre sensiblement au besoin de ces types de capteurs.

Des détails de réalisation d'un tel capteur 1000 de mesure magnétique vectoriel à pompage optique à hélium 4 sont par exemple décrits dans la thèse de Matthieu Le Prado, « Conception, réalisation et application d'un magnétomètre atomique vectoriel », Université de Franche-Comté, 2014.

**Revendications**

**1.** Dispositif (100) de conversion numérique - analogique, comportant au moins :

- un premier convertisseur numérique-analogique, CNA, (102) à réseau R-2R ;
- un deuxième CNA (104) à réseau R-2R et dont une résolution $N_2$ est inférieure à une résolution $N_1$ du premier CNA (102);
- un atténuateur (106) couplé électriquement à une sortie du deuxième CNA (104) et configuré pour délivrer en sortie une tension dont l'amplitude est comprise entre 0,9.q1 et 1,1.q1, avec *q1* correspondant au quantum du premier CNA (102), lorsqu'il reçoit en entrée une tension pleine échelle du deuxième CNA (104) ;
- un additionneur (108) configuré pour additionner une tension de sortie du premier CNA (102) et la tension de sortie de l'atténuateur (106) ;
- un circuit de pilotage numérique (112) configuré pour délivrer sur une entrée de données du premier CNA (102) $N_1$ bits de poids fort d'un signal numérique de N bits destiné à être converti analogiquement par le dispositif (100), et pour délivrer sur une entrée de données du deuxième CNA (104) *(N - N_1)* autres bits du signal numérique de *N* bits, avec $N_2 \geq (N - N_1)$;
- un circuit de génération de référence de tension (116) dont une sortie est couplée électriquement à une entrée d'un circuit de filtrage (114), une sortie du circuit de filtrage (114) étant couplée électriquement à une entrée de référence de tension du premier CNA (102) ;

dans lequel le quantum $q_{total}$ du dispositif (100) est choisi tel que la relation suivante soit vérifiée :

$$q_{total} < \frac{DNL_{crête}}{2\sqrt{3}} q_1$$

avec $q_1$ correspondant au quantum du premier CNA (102) et $DNL_{crête}$ correspondant à la valeur crête du bruit aléatoire ajouté sur chaque échantillon généré correspondant aux défauts différentiels de linéarité du premier CNA (102).

2. Dispositif (100) selon la revendication 1, comportant en outre un circuit de suppression de glitch (110) comprenant, dans une première configuration, une entrée de données couplée électriquement à une sortie de l'additionneur (108), une entrée de commande couplée au circuit de pilotage numérique (112) et dont une sortie forme une sortie du dispositif (100), ou, dans une deuxième configuration, l'entrée de données couplée électriquement à une sortie du premier CNA (102), l'entrée de commande couplée au circuit de pilotage numérique (112) et la sortie couplée à une des entrées de l'additionneur (108).

3. Dispositif (100) selon la revendication 2, dans lequel le circuit de suppression de glitch (110) comporte un amplificateur opérationnel (132) monté en suiveur et un dispositif de type échantillonneur - bloqueur (128, 130) dont une entrée forme l'entrée de données du circuit de suppression de glitch (110) et dont une sortie est couplée à une entrée non inverseuse de l'amplificateur opérationnel (132) monté en suiveur, et dans lequel le circuit de pilotage numérique (112) est configuré pour délivrer, sur une entrée de commande d'un interrupteur commandé (128) du dispositif de type échantillonneur - bloqueur (128, 130) formant l'entrée de commande du circuit de suppression de glitch (110), un signal de commande d'ouverture ou de fermeture de l'interrupteur commandé (128).

4. Dispositif (100) selon l'une des revendications précédentes, dans lequel le circuit de filtrage (114) est configuré pour mettre en œuvre un filtrage passe-bas d'une référence de tension destinée à être appliquée sur son entrée.

5. Dispositif (100) selon la revendication 4, dans lequel le circuit de filtrage (114) comporte au moins un circuit R-C (118, 120) et un amplificateur opérationnel (122) monté en suiveur, configurés tels qu'une entrée du circuit R-C (118, 120) soit couplée électriquement à la sortie du circuit de génération de référence de tension (116), qu'une sortie du circuit R-C (118, 120) soit couplée à une entrée non inverseuse de l'amplificateur opérationnel (122) et qu'une sortie de l'amplificateur opérationnel (122) soit couplée à l'entrée de référence de tension du premier CNA (102).

6. Dispositif (100) selon la revendication 4, dans lequel le circuit de filtrage (114) comporte au moins :

- un circuit R-C (118, 120) et un amplificateur opérationnel (122) monté en suiveur, configurés tels qu'une entrée non-inverseuse de l'amplificateur opérationnel (122) soit couplée électriquement à la sortie du circuit de génération de référence de tension (116), qu'une sortie de l'amplificateur opérationnel (122) soit couplée à une entrée du circuit R-C (118, 120) et qu'une sortie du circuit R-C (118, 120) soit couplée à l'entrée de référence de tension du premier CNA (102) ;
- un élément résistif de contre-réaction (124) couplé entre l'entrée inverseuse de l'amplificateur opérationnel (122) et l'entrée de référence de tension du premier CNA (102) ;
- un élément capacitif de contre-réaction (126) couplé entre l'entrée inverseuse de l'amplificateur opérationnel (122) et la sortie de l'amplificateur opérationnel (122).

7. Dispositif (100) selon l'une des revendications précédentes, dans lequel $N_1 \geq 16$ et/ou dans lequel $N_2 \geq 4$.

8. Dispositif (100) selon l'une des revendications précédentes, dans lequel $N_2 > (N - N_1)$, et les $N_2 - (N - N_1)$ bits de poids fort du deuxième CNA sont configurés pour être mis à 0.

9. Capteur (1000) comprenant au moins :

- un élément sensible (1002) configuré pour mesurer une grandeur physique et délivrer en sortie un signal analogique représentatif de la grandeur physique mesurée ;
- un dispositif de conversion analogique - numérique et de traitement (1004) recevant en entrée le signal analogique représentatif de la grandeur physique mesurée ;
- un correcteur (1006) dont une entrée est couplée à une sortie du dispositif de conversion analogique - numérique et de traitement (1004) et une sortie sur laquelle un signal de mesure de la grandeur physique est destiné à être délivré ;
- un dispositif de conversion numérique - analogique (100) selon l'une des revendications précédentes, comprenant une entrée de données à convertir couplée à la sortie du correcteur (1006) ;
- une chaîne électronique de réinjection (1008, 1010, 1012) comprenant une entrée couplée à une sortie du dispositif de conversion numérique - analogique (100), et une sortie couplée à une entrée de l'élément sensible (1002) qui est configuré pour soustraire un signal de sortie de la chaîne électronique de réinjection à la grandeur physique destinée à être mesurée.

10. Capteur (1000) selon la revendication 9, dans lequel l'élément sensible (1002) est configuré pour mesurer un champ magnétique.

11. Capteur (1000) selon la revendication 10, configuré pour former un magnétomètre de type fluxgate ou un magnétomètre vectoriel à pompage optique.

**Patentansprüche**

1. Vorrichtung (100) zur Digital-Analog-Umwandlung, die mindestens Folgendes aufweist:

   - einen ersten Digital-Analog-Wandler, CNA, (102) mit R-2R-Netzwerk;
   - einen zweiten CNA (104) mit R-2R-Netzwerk, dessen Auflösung $N_2$ niedriger ist als eine Auflösung $N_1$ des ersten CNA (102);
   - einen Dämpfer (106), der elektrisch mit einem Ausgang des zweiten CNA (104) gekoppelt und so konfiguriert ist, dass er an dem Ausgang eine Spannung ausgibt, deren Amplitude zwischen *0,9.q1* und *1,1.q1* liegt, wobei $q_1$ dem Quantum des ersten CNA (102) entspricht, wenn er an dem Eingang eine Vollspannung des zweiten CNA (104) empfängt;
   - einen Addierer (108), der so konfiguriert ist, dass er eine Ausgangsspannung des ersten CNA (102) und die Ausgangsspannung des Dämpfers (106) addiert;
   - eine digitale Steuerschaltung (112), die so konfiguriert ist, dass sie an einem Dateneingang des ersten CNA (102) $N_1$ Bits mit hohem Gewicht eines digitalen Signals von N Bits ausgibt, das von der Vorrichtung (100) analog umgewandelt werden soll, und dass sie an einem Dateneingang des zweiten CNA (104) $(N - N_1)$ weitere Bits des digitalen Signals von $N$ Bits ausgibt, wobei $N_2 \geq (N - N_1)$;
   - eine Schaltung zum Erzeugen einer Spannungsreferenz (116), deren Ausgang elektrisch mit einem Eingang einer Filterschaltung (114) gekoppelt ist, wobei ein Ausgang der Filterschaltung (114) elektrisch mit einem Spannungsreferenzeingang des ersten CNA (102) gekoppelt ist;
   wobei das Quantum $q_{gesamt}$ der Vorrichtung (100) so ausgewählt ist, dass folgende Beziehung überprüft wird:

$$q_{gesamt} < \frac{DNL_{Spitze}}{2\sqrt{3}} q_1$$

   wobei $q_1$ dem Quantum des ersten CNA (102) entspricht und $DNL_{Spitze}$ dem Spitzenwert des zufälligen Rauschens entspricht, das auf jede erzeugte Probe hinzugefügt wird und den Differenzialfehlern der Linearität des ersten CNA (102) entspricht.

2. Vorrichtung (100) nach Anspruch 1, die weiter eine Störungsunterdrückungsschaltung (110) aufweist, die in einer ersten Konfiguration einen Dateneingang, der elektrisch mit einem Ausgang des Addierers (108) gekoppelt ist, einen Steuereingang, der mit der digitalen Steuerschaltung (112) gekoppelt ist und dessen Ausgang einen Ausgang der Vorrichtung (100) bildet, oder in einer zweiten Konfiguration den Dateneingang, der elektrisch mit einem Ausgang des ersten CNA (102) gekoppelt ist, den Steuereingang, der mit der digitalen Steuerschaltung (112) gekoppelt ist, und den Ausgang umfasst, der mit einem der Eingänge des Addierers (108) gekoppelt ist.

3. Vorrichtung (100) nach Anspruch 2, wobei die Störungsunterdrückungsschaltung (110) einen als Folger montierten Betriebsverstärker (132) und eine Vorrichtung des Typs Probenehmer-Blockierer (128, 130) aufweist, deren Eingang den Dateneingang der Störungsunterdrückungsschaltung (110) bildet und deren Ausgang mit einem nichtinvertierenden Eingang des als Folger montierten Betriebsverstärkers (132) gekoppelt ist, und wobei die digitale Steuerschaltung (112) so konfiguriert ist, dass sie an einem Steuereingang eines gesteuerten Schalters (128) der Vorrichtung vom Typ Probenehmer - Blockierer (128, 130), der den Steuereingang der Störungsunterdrückungsschaltung (110) bildet, ein Steuersignal zum Öffnen oder Schließen des gesteuerten Schalters (128) ausgibt.

4. Vorrichtung (100) nach einem der vorhergehenden Ansprüche, wobei die Filterschaltung (114) so konfiguriert ist, dass sie eine Tiefpassfilterung einer Spannungsreferenz umsetzt, die an ihren Eingang angelegt werden soll.

5. Vorrichtung (100) nach Anspruch 4, wobei die Filterschaltung (114) mindestens eine R-C-Schaltung (118, 120) und einen als Folger montierten Betriebsverstärker (122) aufweist, die so konfiguriert sind, dass ein Eingang der R-C-Schaltung (118, 120) elektrisch mit dem Ausgang der Spannungsreferenzerzeugungsschaltung (116) gekoppelt ist, ein Ausgang der R-C-Schaltung (118, 120) mit einem nichtinvertierenden Eingang des Betriebsverstärkers (122) gekoppelt ist und ein Ausgang des Betriebsverstärkers (122) mit dem Spannungsreferenzeingang des ersten CNA (102) gekoppelt ist.

6. Vorrichtung (100) nach Anspruch 4, wobei die Filterschaltung (114) mindestens Folgendes aufweist:

   - eine R-C-Schaltung (118, 120) und einen als Folger montierten Betriebsverstärker (122), die so konfiguriert sind, dass ein nichtinvertierender Eingang des Betriebsverstärkers (122) mit dem Ausgang der Spannungsreferenzerzeugungsschaltung (116) elektrisch gekoppelt ist, dass ein Ausgang des Betriebsverstärkers (122) mit einem Eingang der R-C-Schaltung (118, 120) gekoppelt ist und dass ein Ausgang der R-C-Schaltung (118, 120) mit dem Spannungsreferenzeingang der ersten CNA (102) gekoppelt ist;
   - ein Gegenreaktionswiderstandselement (124), das zwischen dem invertierenden Eingang des Betriebsverstärkers (122) und dem Spannungsreferenzeingang des ersten CNA (102) gekoppelt ist;
   - ein kapazitives Gegenreaktionselement (126), das zwischen dem invertierenden Eingang des Betriebsverstärkers (122) und dem Ausgang des Betriebsverstärkers (122) gekoppelt ist.

7. Vorrichtung (100) nach einem der vorhergehenden Ansprüche, wobei $N_1 \geq 16$ und/oder $N_2 \geq 4$.

8. Vorrichtung (100) nach einem der vorhergehenden Ansprüche, wobei $N_2 > (N - N_1)$ ist und die $N_2 - (N - N_1)$ Bits mit hohem Gewicht des zweiten CNA so konfiguriert sind, dass sie auf 0 gesetzt werden.

9. Sensor (1000), umfassend mindestens:

   - ein empfindliches Element (1002), das so konfiguriert ist, dass es eine physikalische Größe misst und an dem Ausgang ein analoges Signal liefert, das für die gemessene physikalische Größe repräsentativ ist;
   - eine Vorrichtung zur Analog-Digital-Umwandlung und Verarbeitung (1004), die an dem Eingang das analoge Signal empfängt, das für die gemessene physikalische Größe repräsentativ ist;
   - einen Korrektor (1006), dessen Eingang mit einem Ausgang der Vorrichtung zur Analog-Digital-Umwandlung und Verarbeitung (1004) gekoppelt ist, und einen Ausgang, an dem ein Messsignal der physikalischen Größe ausgegeben werden soll;
   - eine Vorrichtung zur Digital-Analog-Umwandlung (100) nach einem der vorhergehenden Ansprüche, umfassend einen mit dem Ausgang des Korrektors (1006) gekoppelten umzuwandelnden Dateneingang;
   - eine elektronische Rückkopplungskette (1008, 1010, 1012) umfassend einen Eingang, der mit einem Ausgang der Vorrichtung (100) zur Digital-Analog-Umwandlung gekoppelt ist, und einen Ausgang, der mit einem Eingang des empfindlichen Elements (1002) gekoppelt ist, das so konfiguriert ist, dass es ein Ausgangssignal der elektronischen Rückkopplungskette von der zu messenden physikalischen Größe subtrahiert.

10. Sensor (1000) nach Anspruch 9, wobei das Sensorelement (1002) zum Messen eines Magnetfelds konfiguriert ist.

11. Sensor (1000) nach Anspruch 10, der so konfiguriert ist, dass er ein Fluxgate-Magnetometer oder ein optisch gepumptes Vektormagnetometer bildet.

## Claims

1. A digital-to-analogue conversion device (100), comprising at least:

- a first digital-to-analogue converter, DAC, (102) with R-2R network;
- a second DAC (104) with R-2R network and a resolution $N_2$ of which is lower than a resolution $N_1$ of the first DAC (102);
- an attenuator (106) electrically coupled to an output of the second DAC (104) and configured to output a voltage whose amplitude is between 0.9xql and 1.1xql, with $q_1$ corresponding to the quantum of the first DAC (102), when it receives as an input a full-scale voltage of the second DAC (104);
- an adder (108) configured to add an output voltage of the first DAC (102) and the output voltage of the attenuator (106) ;
- a digital drive circuit (112) configured to deliver on a data input of the first DAC (102) $N_1$ most significant bits of a N-bit digital signal intended to be analogueconverted by the device (100), and to deliver on a data input of the second DAC (104) ($N - N_1$) other bits of the N-bit digital signal, with $N_2 \geq ( N - N_1)$;
- a voltage reference generation circuit (116) an output of which is electrically coupled to an input of a filtering circuit (114), an output of the filtering circuit (114) being electrically coupled to a voltage reference input of the first DAC (102);

wherein the quantum $q_{total}$ of the device (100) is chosen such that the following relationship is verified:

$$q_{total} < \frac{DNL_{peak}}{2\sqrt{3}} q_1$$

with $q_1$ corresponding to the quantum of the first DAC (102) and $DNL_{peak}$ corresponding to the peak value of the random noise added to each sample generated corresponding to the differential linearity defects of the first DAC (102).

2.  The device (100) according to claim 1, further comprising a glitch suppression circuit (110) comprising, in a first configuration, a data input electrically coupled to an output of the adder (108), a control input coupled to the digital drive circuit (112) and an output of which forms an output of the device (100), or, in a second configuration, the data input electrically coupled to an output of the first DAC (102), the control input coupled to the digital drive circuit (112) and the output coupled to one of the inputs of the adder (108).

3.  The device (100) according to claim 2, wherein the glitch suppression circuit (110) includes a follower-mounted operational amplifier (132) and a sample-and-hold type device (128, 130) one input of which forms the data input of the glitch suppression circuit (110) and one output of which is coupled to a non-inverting input of the follower-mounted operational amplifier (132), and wherein the digital drive circuit (112) is configured to deliver, on a control input of a controlled switch (128) of the sample-and-hold type device (128, 130) forming the control input of the glitch suppression circuit (110), a control signal for opening or closing the controlled switch (128).

4.  The device (100) according to one of the preceding claims, wherein the filtering circuit (114) is configured to implement low-pass filtering on a voltage reference to be applied to its input.

5.  The device (100) according to claim 4, wherein the filtering circuit (114) includes at least one R-C circuit (118, 120) and a follower-mounted operational amplifier (122), configured such that an input of the R-C circuit (118, 120) is electrically coupled to the output of the voltage reference generation circuit (116), that an output of the R-C circuit (118, 120) is coupled to a non-inverting input of the operational amplifier (122) and that an output of the operational amplifier (122) is coupled to the voltage reference input of the first DAC (102).

6.  The device (100) according to claim 4, wherein the filtering circuit (114) further comprises:

    - an R-C circuit (118, 120) and a follower-mounted operational amplifier (122), configured such that a non-inverting input of the operational amplifier (122) is electrically coupled to the output of the voltage reference generation circuit (116), that an output of the operational amplifier (122) is coupled to an input of the R-C circuit (118, 120) and that an output of the R-C circuit (118, 120) is coupled to the voltage reference input of the first DAC (102);
    - a feedback resistive element (124) coupled between the inverting input of the operational amplifier (122) and the voltage reference input of the first DAC (102);
    - a feedback capacitive element (126) coupled between the inverting input of the operational amplifier (122) and the output of the operational amplifier (122).

7. The device (100) according to one of the preceding claims, wherein $N_2 \geq 16$ and/or wherein $N_2 \geq 4$.

8. The device (100) according to one of the preceding claims, wherein $N_2 > (N - N_1)$, and the $N_2 - (N - N_1)$ most significant bits of the second DAC are configured to be set to 0.

9. A sensor (1000) comprising at least:

   - a sensing element (1002) configured to measure a physical quantity and output an analogue signal representative of the physical quantity measured;
   - an analogue-to-digital conversion and processing device (1004) receiving as an input the analogue signal representative of the physical quantity measured;
   - a corrector (1006) an input of which is coupled to an output of the analogue-to-digital conversion and processing device (1004) and an output to which a measurement signal of the physical quantity is intended to be delivered;
   - a digital-to-analogue conversion device (100) according to one of the preceding claims, comprising a data input to be converted, which input is coupled to the output of the corrector (1006);
   - a reinjection electronic chain (1008, 1010, 1012) comprising an input coupled to an output of the digital-to-analogue conversion device (100), and an output coupled to an input of the sensing element (1002) which is configured to subtract an output signal of the reinjection electronic chain from the physical quantity intended to be measured.

10. The sensor (1000) according to claim 9, wherein the sensing element (1002) is configured to measure a magnetic field.

11. The sensor (1000) according to claim 10, configured to form a fluxgate type magnetometer or an optically pumped vector magnetometer.

FIG.1

FIG.2

FIG.3

110

128                    132

V_out DAC

Commande
commutateur

130

Vout

FIG.4

| Data DAC | Data n | Data n+1 |
|---|---|---|

Vout_DAC n          Vout_DAC n+1

Vout_DAC                    Glitch

Commande
commutateur

t₁      t₂

Vout n                    Vout n+1

Vout

FIG.5

102

$R_{DAC\_102}$        108    V_out DAC

$V_{DAC\ 102}$

104

$R_{DAC\_104}$        $R_{inj}$    106

$V_{DAC\ 104}$

FIG.6

1002   1004   1006   1000

Grandeur
physique à
mesurer

Grandeur de
contre-
réaction

1008   100

Mesure de la
grandeur physique

FIG.7

1002   1004   1006   1000

Champ
magnétique à
mesurer

Champ de
compensation

1012   1010   100

Mesure du champ

FIG.8

114   116   100

112   102   110   108

104   106   $V_{out}$

FIG.9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4410879 A

**Littérature non-brevet citée dans la description**

- **2016** ; **RAHUL PRAKASH**. *Using a 16-bit DAC to generate a cost-efficient 18-DAC transfer function*
- **MAURICE EGAN**. The 20-Bit DAC Is the Easiest Part of a 1-ppm-Accurate Precision Voltage Source. *Analog Dialogue*, April 2010, 44-04
- Evaluation Board User Guide Evaluation Board for a 20-Bit, Serial Input, Voltage Output DAC. *Analog Devices*

- **MAXIM**. *Deglitching Techniques for High-Voltage R-2R DACs Deglitching Techniques for High-Voltage R-2R DACs*
- **EGAN MAURICE**. *The 20-Bit DAC Is the Easiest Part of a 1-ppm-Accurate Precision Voltage Source*
- **SHAH ANSHUL**. *Why Does Voltage Reference Noise Matter?*
- **MATTHIEU LE PRADO**. Conception, réalisation et application d'un magnétomètre atomique vectoriel. Université de Franche-Comté, 2014